# EUROPÄISCHE PATENTSCHRIFT

(11) **EP 1 024 530 B1**
(45) Veröffentlichungstag und Bekanntmachung des Hinweises auf die Patenterteilung: **19.10.2005**
(21) Anmeldenummer: 99811185.0
(22) Anmeldetag: 21.12.1999
(51) Int. Cl.: H01L 23/48

(54) **Leistungshalbleitermodul**
Semiconductor power module
Module semiconducteur de puissance

(30) Priorität: 27.01.1999 DE 19903245
(43) Veröffentlichungstag der Anmeldung: 02.08.2000
(73) Patentinhaber: ABB Schweiz AG, 5400 Baden (CH)
(72) Erfinder: Lang, Thomas, Dr., 8051 Zürich (CH); Bucher, Benno, 8049 Zürich (CH); Frey, Toni, Dr., Singapore 257772 (SG)
(74) Vertreter: ABB Patent Attorneys

(56) Entgegenhaltungen:
- EP-A- 0 138 048
- EP-A- 0 246 574
- DE-A- 2 725 847
- DE-A- 19 530 264
- US-A- 4 956 696

## Beschreibung

### TECHNISCHES GEBIET

Die Erfindung bezieht sich auf das Gebiet der Leistungselektronik. Sie geht aus von einem Leistungshalbleitermodul nach dem Oberbegriff des ersten Anspruchs.

### STAND DER TECHNIK

Ein solches Leistungshalbleitermodul wird bereits in der Offenlegungsschrift DE 195 30 264 A1 beschrieben. Es handelt sich dabei um ein sogenanntes Druckkontakt-Halbleitermodul, bei welchem mehrere Halbleiterchips mit ihrer ersten Hauptelektrode auf einer Grundplatte angeordnet sind. Die zweiten Hauptelektroden der Chips werden von einer Mehrzahl von Kontaktstempeln elektrisch kontaktiert. Die Grundplatte ist mit einem ersten Hauptanschluss und die Kontaktstempel sind mit einem zweiten Hauptanschluss verbunden.

Es ist schwierig, die einzelnen Chips auf eine gemeinsame Höhe geschweige denn planparallel zu löten. In der obengenannten Offenlegungsschrift wird die Lage jedes einzelnen Kontaktstempels entsprechend dem Abstand zwischen dem zu kontaktierenden Halbleiterchip und dem zweiten Hauptanschluss individuell eingestellt. Dadurch können die Anforderungen an die Planparallelität der Chipoberflächen reduziert werden. Die Position der beweglich gelagerten Kontaktstempel konstanter Länge wird durch eine Feder eingestellt, welche in einer für die Aufnahme der Kontaktstempel vorgesehenen Bohrung angeordnet ist. Die auf das Modul wirkende Kraft wird über diese Federn auf die einzelnen Halbleiterchips übertragen.

Die in obengenannter Offenlegungsschrift angegebene Lösung weist den Nachteil auf, dass der Strom durch die Feder fliessen muss. Die elektrische Leitfähigkeit der Feder selbst und insbesondere diejenige des Übergangs zwischen der Feder und dem Kontaktstempel oder dem zweiten Hauptanschluss ist jedoch oftmals ungenügend.

Gegenstand der Offenlegungsschrift DE 27 25 847 A1 ist eine Anordnung zur Druckkontaktierung eines Halbleiterchips in einer Gleichrichterzelle. Der Halbleiterchip ist über eine erste Hauptelektrode mit einer Basisplatte in elektrischer Verbindung und mit einer zweiten Hauptelektrode über ein gefedertes Kontaktelement mit einer Deckplatte in elektrischer Verbindung. Das gefederte Kontaktelement besteht aus einem Kontaktelement und mindestens einer u-förmig gebogenen Feder, welche einen ersten und einen zweiten Schenkel ausweist und mit einem ersten Schenkel das mit der zweiten Hauptelektrode in Verbindung stehende Ende des Kontaktelements andrückt. Der zweite Schenkel ist gegen das Gehäuse abgestützt. Auf das zweite Ende des Kontaktelements wird eine Quetschhülse aufgesetzt und die Anordnung bestehend aus dem Ende des Kontaktelements und der Quetschhülse aus dem Gehäuse hinausgeführt. Durch die Feder wird nur das mit der zweiten Hauptelektrode in Verbindung stehende Ende des Kontaktelements angedrückt.

Aus der Schrift DE 1 514 150 ist es bekannt, eine Druckkontaktierung in einem Silizium-Gleichrichter mit einem Silikon-Gummistopfen oder einer Blattfeder zu erzeugen. Ein Halbleiterchip ist mit einer Elektrode verbunden, auf der sich eine Ringscheibe befindet. Auf der Scheibe ist ein Silikon-Gummistopfen oder eine gegen das Gehäuse isolierte Blattfeder angeordnet, welche über einen Glasring gegen das Gehäuse gepresst wird. Als Kontaktelement wird ein Kupferdraht verwendet, der an einem Ende mittels einer Lötverbindung mit der einen Elektrode verbunden ist und am anderen Ende in eine Metallhülse gepresst wird. Die in der Schrift zu lösende Aufgabe ist, Ermüdungserscheinungen von Weichlötstellen zwischen Halbleiterchip, Kontaktelementen und Elektroden durch Temperaturwechsel zu vermeiden. Bei dieser Anordnung ist es nur vorgesehen, ein einzelnes Halbleitermodul auf einer Basisplatte anzuordnen. Es wird zudem nur die Lötverbindung des mit der zweiten Hauptelektrode in Verbindung stehenden Endes des Kontaktelements angedrückt.

### DARSTELLUNG DER ERFINDUNG

Aufgabe der vorliegenden Erfindung ist es, ein Leistungshalbleitermodul anzugeben, bei welchem alle Halbleiterchips unabhängig von ihrem Abstand zum zweiten Hauptanschluss mit demselben Druck beaufschlagt werden und bei welchem die elektrische Leitfähigkeit der für die Kontaktierung vorgesehenen Mittel verbessert ist. Diese Aufgabe wird durch ein Leistungshalbleitermodul mit den Merkmalen des ersten Anspruchs gelöst.

Kern der Erfindung ist es, die für die elektrische Verbindung zwischen den Halbleiterchips und dem zweiten Hauptanschluss vorgesehenen Mittel von den Federelementen, welche für die für alle Halbleiterchips einheitliche Auflagekraft verantwortlich sind, zu trennen. Für jeden Halbleiterchip wird eine elektrische Verbindung zum zweiten Hauptanschluss des Moduls geschaffen, welche sich durch eine gute Leitfähigkeit und kleine Übergangswiderstände auszeichnet.

Dazu sind Kontaktelemente vorgesehen, welche zwei ebene Kontaktflächen aufweisen. Der Abstand zwischen diesen Kontaktflächen wird durch ein Verbindungselement überbrückt. Dieses Verbindungselement muss flexibel sein und weist vorzugsweise die Form eines Bügels oder eines drahtartigen Leiters auf.

Jedes Kontaktelement ist durch ein Federelement gespreizt. Dabei werden die Kontaktflächen einerseits an die Deckplatte und andererseits auf den Halbleiterchip gedrückt und ermöglichen so einen geringen Kontaktwiderstand. Die Übertragung der Auflagekraft erfolgt durch das gespannte Federelement, welches zwischen den Kontaktflächen angeordnet ist und zur elektrischen Leitung wenig bis gar nichts beiträgt.

Leistungshalbleitermodule mit druckkontaktierten Halbleiterchips sind im Allgemeinen kurzschlussfest, da keine dünnen Bonddrähte vorhanden sind, welche unter Überlast schmelzen können. Allerdings sind bei der Druckkontaktierung ohne besondere Vorsichtsmassnahmen die empfindlichen Halbleiterchips, insbesondere IGBT (Insulated Gate Bipolar Transistor) Chips mechanischen Fehl- oder Überbelastungen ausgesetzt, welche zur Zerstörung der Chips führen können. Insbesondere beim Einspannen seriegeschalteter Module in Stapel kann es zu Beschädigungen kommen. Dies wird in einer bevorzugten Ausführungsform der vorliegenden Erfindung vermieden, indem zwischen dem ersten und zweiten Hauptanschluss Stützelemente zur Aufnahme einer eventuellen Überbelastung vorgesehen sind. Diese begrenzen den Federweg und somit die maximale von dem Federelement übertragene Auflagekraft. Sobald die Deckplatte auf den Stützen aufliegt, wird jede weitere Belastung von diesen aufgenommen und der Kontaktdruck auf die Halbleiterchips wird von der äusseren Einspannbelastung entkoppelt.

Gemäss einer weiteren bevorzugten Ausführungsform können die aus Feder- und Kontaktelement gebildeten Einheiten vorgefertigt und bei der Bestückung des Halbleitermoduls einfach auf die Chips aufgesetzt werden. Die erwähnte Einheit ist noch kompakter und leichter zu handhaben, falls das Federelement vorgespannt ist, indem es durch geeignete Rückhaltemittel an einer vollständigen Entspannung gehindert wird. Dies erlaubt insbesondere eine kostengünstigere da vereinfachte Herstellung der Halbleitermodule.

Die Kontaktierung der Chips mittels der erfindungsgemässen Kombination von Kontaktelement und Federelement gewährleistet einen permanenten niederohmigen Übergangswiderstand zwischen den Gehäusekontakten und dem Chip. Dadurch wird bei Ausfall eines Chips der ganze Nominalstrom über den defekten Chip geleitet, ohne dass die entsprechenden Kontakte Schaden nehmen.

Weitere vorteilhafte Ausführungsformen gehen aus den abhängigen Ansprüchen hervor.

### KURZE BESCHREIBUNG DER FIGUREN

Nachfolgend wird die Erfindung anhand von Ausführungsbeispielen im Zusammenhang mit den Zeichnungen näher erläutert. Es zeigen:
Fig.1 einen Schnitt durch einen Teil eines erfindungsgemässen Leistungshalbleitermoduls nach einer ersten Ausführungsform und
Fig.2 einen Schnitt durch einen Teil eines erfindungsgemässen Leistungshalbleitermoduls nach einer zweiten Ausführungsform.

Die in den Zeichnungen verwendeten Bezugszeichen und deren Bedeutung sind in der Bezugszeichenliste zusammengefasst. Grundsätzlich sind gleiche Teile mit denselben Bezugszeichen versehen, sofern nicht aus Gründen der Übersichtlichkeit auf die Wiederholung eines Bezugszeichens verzichtet wurde.

### WEGE ZU AUSFÜHRUNG DER ERFINDUNG

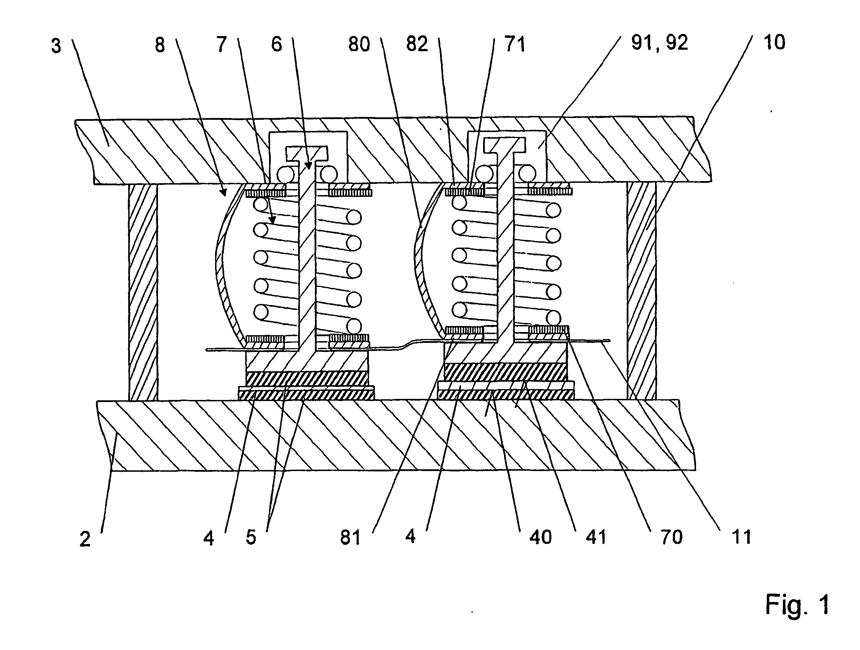

In Fig.1 ist ein Ausschnitt aus einem Schnitt durch ein Hochleistungshalbleitermodul nach einer bevorzugten Ausführungsform der Erfindung gezeigt. In einem gemeinsamen Gehäuse sind eine Vielzahl von einzelnen Halbleiterchips 4 getrennt nebeneinander angeordnet, wobei in Fig. 1 nur zwei einzelne Chips 4 dargestellt sind. Vorzugsweise handelt es sich bei den Halbleiterchips um IGBT-Chips oder Diodenchips oder eine Kombination dieser zwei Arten von Chips. Nicht dargestellt sind in Fig.1 die Gateanschlüsse zur Ansteuerung der Halbleiterchips.

Das Gehäuse wird durch eine Basisplatte 2, eine Deckplatte 3 und eine Gehäusewand gebildet. Die Basisplatte 2, welche einen ersten Hauptanschluss 20 des Moduls bildet, und die Deckplatte 3 welche einen zweiten Hauptanschluss 30 des Moduls bildet, können als massive Kupferblöcke ausgebildet sein. In der Basisplatte 2 sind zudem hier nicht gezeigte Kühlvorrichtungen integriert. Die Halbleiterchips 4 umfassen auf der Unter- und Oberseite eine erste 40 und eine zweite 41 metallisierte Hauptelektrode. Die zweite Hauptelektrode 41 jedes Halbleiterchips ist über ein Kontaktelement 8 mit der Deckplatte 3 elektrisch verbunden. Zwischen der ersten Hauptelektrode 40 und der Basisplatte 2 einerseits und zwischen der zweiten Hauptelektrode 41 und dem Kontaktelement 8 andererseits können weitere Folien, Platten und / oder Lötschichten vorgesehen sein. Als Beispiel für eine derartige Zwischenschicht seien Platten 5 aufgeführt, welche in ihrer thermischen Ausdehnung an das Silizium- Halbleitermaterial angepasst und aus Materialien wie Mo, Cu, oder Mo-Cu Kompositen gefertigt sind.

Um den Übergangswiderstand zwischen der zweiten Hauptelektrode 41 eines Halbleiterchips 4 und dem Kontaktelement 8 gering zu halten umfasst letzteres eine erste ebene Kontaktfläche 81. Diese liegt auf der zweiten Hauptelektrode 41 oder auf der obersten der erwähnten Zwischenschichten 5 auf. Ein Federelement 7 ist derart angeordnet, dass das Kontaktelement 8 durch das Federelement 7 gespreizt wird. Eine zweite ebene Kontaktfläche 82 des Kontaktelementes 8 wird dementsprechend durch das gespannte Federelement 7 gegen die Deckplatte 3 gedrückt. Zwischen dem Federelement 7 und den zwei Kontaktflächen 81, 82 befinden sich eine erste 70 und eine zweite 71 Unterlagsscheibe. Sind diese Unterlagsscheiben 70, 71 elektrisch isolierend ausgebildet, so wird auch durch ein metallisches Federelement 7 überhaupt kein Strom fliessen.

Die durch das gespannte Federelement 7 auf die Halbleiterchips 4 und die Deckplatte 3 übertragene Auflagekraft wird durch den Druck kompensiert, welcher auf die Hauptanschlussflächen 20, 30 des Moduls im seinem eingespannten Zustand ausgeübt wird.

Weil sich der Abstand zwischen den zwei Kontaktflächen 81, 82 eines Kontaktelementes 8 erst im eingespannten Modul nicht mehr ändert, muss er durch ein flexibles leitendes Verbindungselement 80 überbrückt werden. Insbesondere ist das Federelement 7 vor seinem Einbau ausgedehnter, d.h. weniger gespannt als im einmal eingespannten Modul. Das Verbindungselement 80 kann beispielsweise die Form eines Bügels aufweisen, mehrere Bügel umfassen oder aus einem oder mehreren Drahtstücken gebildet sein. Das Verbindungselement 80 dient erfindungsgemäss ausschliesslich der elektrischen Leitung.

Wie eingangs bereits erläutert, ist die Höhe der Stapel bestehend jeweils aus einem Halbleiterchip 4 sowie Molybdänplatten 5 und Lötschichten innerhalb eines Moduls nicht einheitlich. Es bereitet Schwierigkeiten, die jeweils durch die erste Kontaktfläche 81 des Kontaktelementes 8 zu kontaktierenden, obersten Zwischenschichten alle auf exakt dieselbe Höhe auszurichten. Dies ist insbesondere dann der Fall, wenn verschiedene Arten von Chips in ein und demselben Modul Verwendung finden. Um die Problematik zu verdeutlichen, sind in der Figur 1 die unterschiedlich dicken Chips übertrieben dargestellt. Entsprechend ist die Distanz, welche durch das Kontaktelement überbrückt wird, von Chip zu Chip beziehungsweise von Kontaktelement zu Kontaktelement verschieden. Durch die Verwendung der erfindungsgemässen Kontaktelemente 8 mit flexibler Ausdehnung, d.h. variablem Abstand zwischen den Kontaktflächen 81, 82 stellt dies jedoch kein Problem mehr dar.

Um die Halbleiterchips 4 vor mechanischen Fehl- und Überbelastungen zu schützen sind Stützelemente 10 aus kriechfesten Materialien, vorzugsweise aus Keramik, vorgesehen. Wird nämlich der Druck auf die Hauptanschlussflächen 20, 30 beim Einspannen des Moduls in einen Stapel zu gross, kann ersterer von den Stützelementen 10 aufgenommen werden. Das Federelement 7 wird beim Einspannen des Moduls weiter komprimiert, und zwar maximal so weit, bis die Deckplatte 3 auf den Stützelementen 10 aufliegt. Jede weitere Über- oder Fehlbelastung wird somit nicht mehr an die Halbleiterchips 4 weitergegeben. Die Stützelemente 10 können als einzelne Pfeiler oder als Stützring im Inneren des Moduls ausgebildet sein oder mit der Gehäusewand identisch sein.

Ein weiteres Beispiel für die eingangs genannten Zwischenschichten ist die im Folgenden als Stempelfuss 60 bezeichnete Platte. Sie dient zusätzlich zu der ersten Unterlagsscheibe 70 zur Vergleichmässigung des durch das Federelement 7 ausgeübten Drucks und ist zwischen dem Federelement 7 und dem Chip 4 vorgesehen. Dies ist insbesondere dann angebracht, wenn die Querschnitte von Federelement 7 und Halbleiterchip 4 in Form und Grösse nicht übereinstimmen. Die erste Kontaktfläche 81 des Kontaktelementes 8 kommt dann vorzugsweise zwischen die chipseitige Unterlagsscheibe 70 und den Stempelfuss 60 zu liegen.

Dieser Stempelfuss 60 dient zusätzlich als Basis eines eigentlichen Stempels 6. Ein solcher Stempel 6 umfasst weiter einen Stempelhals 61 und einen daran anschliessenden verbreiterten Stempelkopf 62. Aufgabe eines derart ausgestalteten Stempels 6 ist es, eine vollständige Entspannung des Federelements 7 zu verhindern beziehungsweise für eine gewisse Vorspannung besorgt zu sein. Zu diesem Zweck sind noch weitere Rückhaltemittel 9 notwendig, darunter beispielsweise ein O-Ring 90, welcher zwischen den Stempelkopf 62 und der deckplattenseitigen zweiten Unterlagsscheibe 71 (oder der zweiten Kontaktfläche 82) plaziert wird. Diese zweite Unterlagsscheibe 71 ist mit einer Öffnung versehen, deren Durchmesser etwas grösser ist als derjenige des Stempelkopfes 62. Der O-Ring 90 weist einen Innendurchmesser kleiner als der Durchmesser des Stempelkopfs 62 und einen Aussendurchmesser grösser als der Durchmesser der Öffnung der zweiten Unterlagsscheibe 71 auf. Der dergestalt zwischen Stempelkopf 62 und zweiter Unterlagsscheibe 71 eingeklemmte O-Ring 90 verhindert nun, dass sich das unbelastete Federelement 7 über den Stempelkopf 62 hinaus entspannt. Alternativ zu obigem O-Ring 91 ist ein abnehmbarer Stempelkopf 62 denkbar mit einem Durchmesser, welcher grösser ist als der Durchmesser der Öffnung der zweiten Unterlagsscheibe 71.

Mit diesen Mitteln kann dem Federelement 7 eine beliebige Vorspannung verpasst werden, wodurch der zusätzliche Federweg beim Aufsetzen der Deckplatte 3 bzw. beim Einspannen des Moduls minimiert wird. Die aus vorgespanntem Federelement 7, Stempel 6 und Kontaktelement 8 gebildete Einheit kann als eigenständiges, kompaktes Bauteil hergestellt und als solches in das Modul eingesetzt werden.

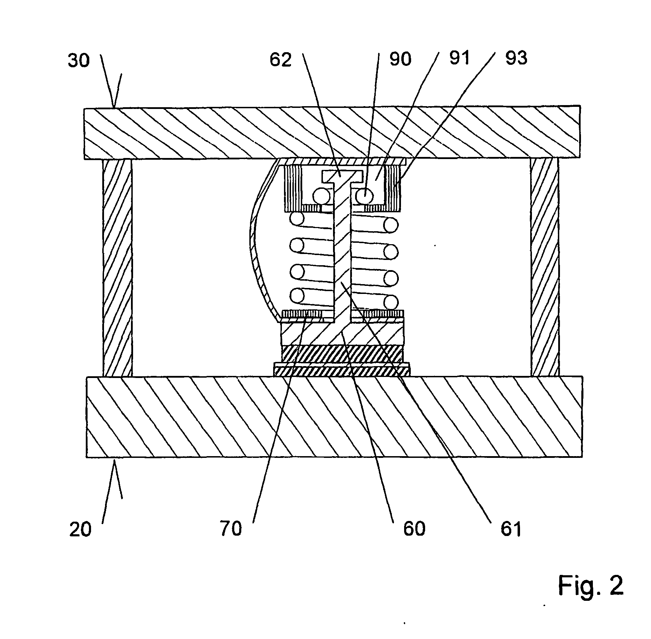

Beim Aufsetzen der Deckplatte 3 beziehungsweise beim Einspannen des Moduls in den Halbleiterstapel wird das Federelement 7 noch etwas weiter zusammengedrückt, wodurch sich der Abstand zwischen dem Stempelkopf 62 und der Deckplatte 3 verringert. Entsprechend muss eine Stempelkopfkammer 91 vorgesehen sein zur Aufnahme der Relativbewegung zwischen Stempelkopf 62 und Rückhaltemittel 9 bzw. Deckplatte 3. Diese Stempelkopfkammer 91 kann durch eine Ausnehmung 92 in der Deckplatte 3 gebildet werden (Fig.1) oder durch ein L-förmiges trichterartiges Profilelement 93, welches deckplattenseitig auf dem Federelement 7 aufliegt. Diese Ausführungsform ist in Fig.2 an einem einzelnen Chip dargestellt. In diesem Fall braucht in der Deckplatte 3 keine Ausnehmung angebracht zu werden. Zudem ist hier die zweite Kontaktfläche 82 durchgehend ausgebildet und weist somit eine grössere Auflagefläche auf.

Das Federelement 7 kann eine Spiralfeder sein, eine oder mehrere Tellerfedern umfassen oder als Zylinder aus einem elastischen Material gefertigt sein. Obschon in den angeführten Beispielen das Federelement 7 stets komprimiert wurde sind auch Ausführungsformen denkbar, bei denen es auf Zug belastet wird. Das Federelement 7 braucht im weiteren nicht notwendigerweise den Stempelhals 61 zu umschliessen sondern kann auch neben diesem angeordnet sein.

Der Stempel 6 und das Federelement 7 können in einer Ebene parallel zu den Hauptanschlüssen 20, 30 einen kreisförmigen Querschnitt aufweisen, d.h. rotationssymmetrisch ausgebildet sein. Eine nur in Figur 1 gezeigte Ausgleichsfolie 11 verbindet die zweiten Hauptelektroden 41 der Halbleiterchips 4 elektrisch und mechanisch untereinander und dient dazu, unterschiedliche Spannungsabfälle zwischen den Halbleiterchips auszugleichen.

### BEZUGSZEICHENLISTE

- 2: Basisplatte
- 20: 1.Hauptanschluss
- 3: Deckplatte
- 30: 2. Hauptanschluss
- 4: Halbleiterchip
- 40: 1. Hauptelektrode
- 41: 2. Hauptelektrode
- 5: Molybdänplatten
- 6: Stempel
- 60: Stempelfuss
- 61: Stempelhals
- 62: Stempelkopf
- 7: Federelement
- 70: 1. Unterlagsscheibe
- 71: 2. Unterlagsscheibe
- 8: Kontaktelement
- 80: Flexibles Verbindungselement, Bügel, Draht
- 81: 1. Kontaktfläche
- 82: 2. Kontaktfläche
- 9: Rückhaltemittel, Vorspannmittel
- 90: O-Ring
- 91: Stempelkopfkammer
- 92: Ausnehmung
- 93: Profilelement
- 10: Stützelement
- 11: Ausgleichsfolie

## Patentansprüche

1. Leistungshalbleitermodul mit einer Basisplatte (2), einer Deckplatte (3), und mindestens einem Halbleiterchip (4), welcher mit einer ersten Hauptelektrode (40) mit der Basisplatte (2) in elektrischer Verbindung steht und welcher mit einer zweiten Hauptelektrode (41) über ein gefedertes elektrisches Kontaktelement (8) mit der Deckplatte (3) in elektrischer Verbindung steht,
**dadurch gekennzeichnet, dass** mindestens ein Federelement (7) vorhanden ist, welches das mindestens eine Kontaktelement (8) in eine die elektrische Verbindung zwischen zweiter Hauptelektrode (41) und Deckplatte (3) erstellende Form derart spreizt, dass das Federelement (7) das mindestens eine Kontaktelement (8) gegen die zweite Hauptelektrode (41) und gegen die Deckplatte (3) drückt.

2. Leistungshalbleitermodul nach Anspruch 1, **dadurch gekennzeichnet, dass** das Kontaktelement (8) zwei Kontaktflächen (81, 82) und ein flexibles elektrisches Verbindungselement (80) umfasst, wobei die erste Kontaktfläche (81) mit der zweiten Hauptelektrode (41) und die zweite Kontaktfläche (82) mit der Deckplatte (3) in elektrischer Verbindung steht, und dass das Federelement (7) zwischen den zwei Kontaktflächen (81, 82) angeordnet ist.

3. Leistungshalbleitermodul nach Anspruch 2, **dadurch gekennzeichnet, dass** das flexible Verbindungselement (80) einen oder mehrere verformbare Bügel aufweist.

4. Leistungshalbleitermodul nach Anspruch 1, **dadurch gekennzeichnet, dass** das Federelement (7) eine Spiralfeder ist oder Tellerfedern oder ein zylindrisches Bauteil aus einem elastischem Material umfasst.

5. Leistungshalbleitermodul nach Anspruch 1, **dadurch gekennzeichnet, dass** das Federelement (7) gegenüber dem Kontaktelement (8) elektrisch isoliert ist.

6. Leistungshalbleitermodul nach Anspruch 1, **dadurch gekennzeichnet, dass** mindestens ein vorzugsweise keramisches Stützelement (10) zwischen der Basisplatte (2) und der Deckplatte (3) vorhanden ist.

7. Leistungshalbleitermodul nach einem der Ansprüche 1-6, **dadurch gekennzeichnet, dass** zur Vorspannung des Federelementes (7) Mittel vorgesehen sind, welche einen Stempel (6), aufweisend einen zwischen Federelement (7) und Halbleiterchip (4) angeordneten Stempelfuss (60), einen Stempelhals (61) und einen in einer Stempelkopfkammer (91) gefangenen Stempelkopf (62), umfassen.

8. Leistungshalbleitermodul nach Anspruch 7, **dadurch gekennzeichnet, dass** der Stempelfuss (60) zwischen der ersten Kontaktfläche (81) und dem Halbleiterchip (4) angeordnet ist.

9. Leistungshalbleitermodul nach Anspruch 8, **dadurch gekennzeichnet, dass** der Stempelhals (61) das Federelement (7) durchsetzt.

10. Leistungshalbleitermodul nach Anspruch 9, **dadurch gekennzeichnet, dass** die Stempelkopfkammer (91) gebildet ist durch eine Ausnehmung (92) in der Deckplatte (3) oder ein zwischen dem Federelement (7) und der Deckplatte (3) angeordnetes L-förmiges Profilelement (93).

## Claims

1. Power semiconductor module having a base plate (2), a cover plate (3) and at least one semiconductor chip (4) which is electrically connected by means of a first main electrode (40) to the base plate (2) and which is electrically connected by means of a second main electrode (41) and via a sprung electrical contact element (8) to the cover plate (3),
**characterized in that** there is at least one spring element (7) which spreads the at least one contact element (8) into a shape which produces the electrical connection between the second main electrode (41) and the cover plate (3) in such a way that the spring element (7) presses the at least one contact element (8) against the second main electrode (41) and against the cover plate (3).

2. Power semiconductor module according to Claim 1, **characterized in that** the contact element (8) comprises two contact surfaces (81, 82) and a flexible electrical connecting element (80), in which case the first contact surface (81) is electrically connected to the second main electrode (41), and the second contact surface (82) is electrically connected to the cover plate (3), and **in that** the spring element (7) is arranged between the two contact surfaces (81, 82).

3. Power semiconductor module according to Claim 2, **characterized in that** the flexible connecting element (80) has one or more deformable clips.

4. Power semiconductor module according to Claim 1, **characterized in that** the spring element (7) is a spiral spring, or comprises plate springs or a cylindrical component composed of an elastic material.

5. Power semiconductor module according to Claim 1, **characterized in that** the spring element (7) is electrically insulated from the contact element (8).

6. Power semiconductor module according to Claim 1, **characterized in that** there is at least one preferably ceramic supporting element (10) between the base plate (2) and the cover plate (3).

7. Power semiconductor module according to one of Claims 1-6, **characterized in that**, in order to prestress the spring element (7), means are provided which comprise a stamp (6) having a stamp foot (60) arranged between the spring element (7) and the semiconductor chip (4), a stamp neck (61) and a stamp head (62) which is held in a stamp head chamber (91).

8. Power semiconductor module according to Claim 7, **characterized in that** the stamp foot (60) is arranged between the first contact surface (81) and the semiconductor chip (4).

9. Power semiconductor module according to Claim 8, **characterized in that** the stamp neck (61) passes through the spring element (7).

10. Power semiconductor module according to Claim 9, **characterized in that** the stamp head chamber (91) is formed by a recess (92) in the cover plate (3), or an L-shaped profile element (93) arranged between the spring element (7) and the cover plate (3).

## Revendications

1. Module semi-conducteur de puissance avec une plaquette de base (2), une plaquette de recouvrement (3) et au moins une puce semi-conductrice (4) qui est en liaison électrique avec une première électrode principale (40) avec la plaquette de base (2) et qui est en liaison électrique avec une deuxième électrode principale (41) via un élément de contact électrique à ressort (8) avec la plaquette de recouvrement (3),
**caractérisé en ce qu'**est présent au moins un élément de ressort (7) qui écarte l'au moins un élément de contact (8) dans une forme établissant la liaison électrique entre la deuxième électrode principale (41) et la plaquette de recouvrement (3), de telle sorte que l'élément de ressort (7) applique l'au moins un élément de contact (8) contre la deuxième électrode principale (41) et contre la plaquette de recouvrement (3).

2. Module semi-conducteur de puissance selon la revendication 1, **caractérisé en ce que** l'élément de contact (8) comprend deux surfaces de contact (81, 82) et un élément de liaison électrique flexible (80), la première surface de contact (81) étant en liaison électrique avec la deuxième électrode principale (41) et la deuxième surface de contact (82) avec la plaquette de recouvrement (3), et que l'élément de ressort (7) est agencé entre les deux surfaces de contact (81, 82).

3. Module semi-conducteur de puissance selon la revendication 2, **caractérisé en ce que** l'élément de liaison flexible (80) présente un ou plusieurs arceaux déformables.

4. Module semi-conducteur de puissance selon la revendication 1, **caractérisé en ce que** l'élément de ressort (7) est un ressort en spirale ou comprend des rondelles-ressorts ou un élément cylindrique en matériau élastique.

5. Module semi-conducteur de puissance selon la revendication 1, **caractérisé en ce que** l'élément de ressort (7) est isolé électriquement par rapport à l'élément de contact (8).

6. Module semi-conducteur de puissance selon la revendication 1, **caractérisé en ce qu'**au moins un élément de support (10) de préférence céramique est présent entre la plaquette de base (2) et la plaquette de recouvrement (3).

7. Module semi-conducteur de puissance selon l'une quelconque des revendications 1 à 6, **caractérisé en ce que** pour la mise en tension initiale de l'élément de ressort (7) sont prévus des moyens qui comprennent un poinçon (6) présentant un pied de poinçon (60) agencé entre l'élément de ressort (7) et la puce semi-conductrice (4), un col de poinçon (61) et une tête de poinçon (62) logée dans une chambre de tête de poinçon (91).

8. Module semi-conducteur de puissance selon la revendication 7, **caractérisé en ce que** le pied de poinçon (60) est agencé entre la première surface de contact (81) et la puce semi-conductrice (4).

9. Module semi-conducteur de puissance selon la revendication 8, **caractérisé en ce que** le col de poinçon (61) traverse l'élément de ressort (7).

10. Module semi-conducteur de puissance selon la revendication 9, **caractérisé en ce que** la chambre de tête de poinçon (91) est formée par un évidement (92) dans la plaquette de recouvrement (3) ou un élément profilé en forme de L (93) agencé entre l'élément de ressort (7) et la plaquette de recouvrement (3).
